Europäisches Patentamt

European Patent Office

Office européen des brevets

(19)

(11) Publication number: **0 160 479 B1**

(12) **EUROPEAN PATENT SPECIFICATION**

(45) Date of publication of patent specification: **02.01.92** (51) Int. Cl.5: **C23C 14/54**

(21) Application number: **85302794.4**

(22) Date of filing: **22.04.85**

(54) Method and apparatus for forming a thin film.

(30) Priority: **24.04.84 JP 81121/84**

(43) Date of publication of application:
**06.11.85 Bulletin 85/45**

(45) Publication of the grant of the patent:
**02.01.92 Bulletin 92/01**

(84) Designated Contracting States:
**DE FR GB**

(56) References cited:
**DE-A- 1 521 247      FR-A- 1 505 687**
**FR-A- 1 577 403      FR-A- 2 075 059**
**FR-A- 2 370 320      GB-A- 1 010 456**
**US-A- 3 168 418      US-A- 3 347 701**
**US-A- 4 024 399**

**PATENT ABSTRACTS OF JAPAN, vol. 8, no. 19 (C-207) [1456], 26th January 1984; & JP-A-58 185 768 (SHINKOU SEIKI K.K.) 29-10-1983**

**PATENT ABSTRACTS OF JAPAN, vol. 7, no. 94 ((E-171) [1239], 20th April 1983; & JP-A-58 17 607 (HITACHI CONDENSER K.K.) 01-02-1983**

**SOLID STATE DESIGN, no. 4, June 1963,**

pages 12-14, Horizon House, Dedham, US;
"Controlled rate electron beam evaporator"

(73) Proprietor: **HITACHI, LTD.**
**6, Kanda Surugadai 4-chome**
**Chiyoda-ku, Tokyo 101(JP)**

(72) Inventor: **Yamamoto, Shigehiko**
**4-36-15, Nakaarai**
**Tokorozawa-shi Saitama-ken(JP)**

(74) Representative: **Calderbank, Thomas Roger et al**
**MEWBURN ELLIS & CO. 2/3 Cursitor Street**
**London EC4A 1BO(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a method of forming a thin film and to an apparatus for carrying out such a method.

In a conventional method of forming a thin film, the material from which the film is to be formed is placed in a boat-like container and is then heated so that the atoms of the material evaporate and become stuck on a pre-prepared substrate. Control of the thickness of the thin film is achieved using e.g. a quartz oscillator close to the substrate. Where control of film thickness with a high level of resolution is necessary, such as in molecular beam epitaxy equipment, a Knudsen cell has often been used as a molecular beam source (evaporation source) of the device. In a Knudsen cell, the total molecular beam flux is determined by the temperature of the molecular source. Furthermore, the spatial distribution of effusion follows a cosine law, and therefore the molecular beam flux reaching the substrate may be determined if the geometrical structure is known. In this case, a quartz oscillator is used as a monitor (see, for example, S. Yamamoto et al., J. Appl. Phys. 46 (1975) 406).

FR-A-1505687 shows a vapour-phase deposition apparatus which incorporates means for measuring the flux of a molecular deposition beam. However, no provision is made in this apparatus for measuring the speed of the beam.

FR-A-2370320 discloses a system wherein the flux of a molecular beam is measured and used, in a feedback control system, to control the rate of evaporation at the source of the beam. However, there is no disclosure of the measurement or control of the speed of the beam.

However, the method of forming a thin film described above does not measure directly the molecular beam reaching the substrate, so that the technique cannot control the energy or speed of the molecular beam. Furthermore, since the relationship between the proportion of the molecular beam reaching the subtrate and the proportion of the molecular beam participating in the formation of the film, i.e. the ability of sticking to the film, is not clear, control of film thickness cannot be achieved completely.

The present invention seeks to provide a method and apparatus which permit the thin film to be deposited more accurately. It does this by a more direct method of measuring the flux and speed of the beam. The beam is converted to pulses and passed through an ionisation chamber. A part of the beam is ionised, the rest passing to the substrate to form the thin film. The ionised part of the beam is used to generate an electrical signal from which the flux and speed may be calculated. The results of that calculation can then be used to control the source of the beam to achieve the desired results.

An embodiment of the invention will now be described in detail, by way of example, with reference to the accompanying drawings, in which:

Figure 1 is a schematic view showing an example of an apparatus for forming a thin film according to the present invention; and

Figures 2(a) and 2(b) are perspective views showing two alternative molecular beam speed selectors, for use with the embodiment of Figure 1, where Figure (a) represents a selector using two choppers and (b) represents a selector using a cylindrical chopper.

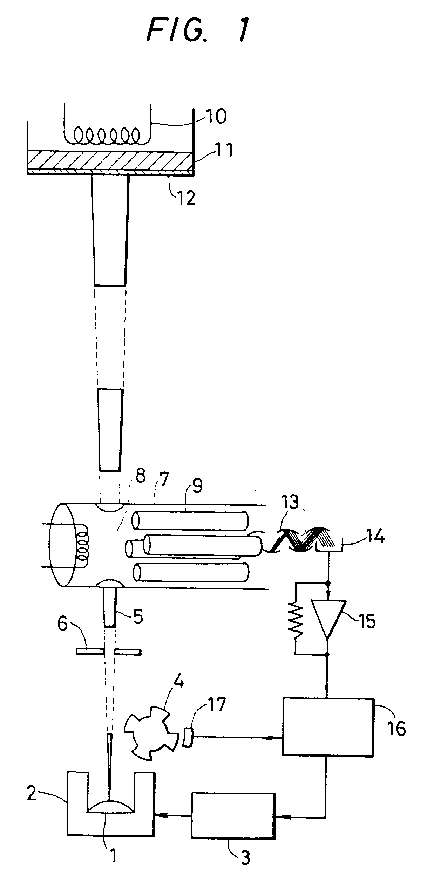

Referring first to Figure 1, material 1 of an element for forming a thin film is stored in a heating container 2, and is heated by the passage of a current. The heating is controlled by a heating controller 3. The material 1 may alternatively heated by electron bombardment heating. The molecular beam emitted from the heating container 2 due to heating is turned on and off by a toothed disc or "chopper" 4 at a speed that can be neglected in conjunction with the film formation, and is converted to a pulsed molecular beam 5.

The expansion of the beam 5 is restricted by an aperture 6, and then the pulsed molecular beam 5 reaches the ion source 8 (a region forming ions) of a quadrupole mass spectrometer 7. Part of the pulsed molecular beam 5 is then ionised by the ion source 8 and is subjected to mass spectroscopy by the quadrupole 9 of the quadrupole mass spectrometer 7. Most of the molecules of the beam, which are not ionised by the ion source 8 of the quadrupole mass spectrometer 7, pass from the spectrometer 7 to the substrate 11, and stick to the surface of that substrate 11. The surface is kept at a suitable temperature by a heater 10, and the molecules form a thin film 12. The substrate 11 can rotate and can also move linearly so that the thin film 12 can be formed uniformly on the surface of the substrate 11.

Ions inside the quadrupole mass spectrometer 7 are used to generate corresponding electrons which are amplified by about $10^6$ times using a multiplier 13, and are collected by a collector 14. Electrons may also be generated directly from the molecules of the beam 5. The current from the collector 14 is converted to an electrical signal by a current-voltage transformer 15 and is sent to a flux and speed measurement device 16. This measurement device 16 also receives the output of a photosensor 17, which detects the timing of the chopper 4 described above, and the signal from photosensor 17 is used as a reference signal for this flux and speed measurement device. A phase sensitive detector or a multi-channel analyser is used for the measurement of the flux and the speed, and the flux and the speed are calculated by a microcomputer on the basis of the result of the mass spectroscopy. The output of the flux and speed measurement device 16 is fed back to the heating controller 3, so that the molecular beam can be emitted under pre-set conditions, and the thickness of the thin film 12 can be controlled. When the molecular beam is emitted by electron bombardment heating, the output of the flux and speed measurement device 16 is fed back to the electron bombardment type heating device to control its power.

When the material 1 is a compound or a mixture and the thickness of the thin film is also controlled, the quadrupole mass spectrometer 7 may be used in the same way as in the embodiment described above and mass spectroscopy may be carried out for each element of the material 1 on a time series basis. The result of the mass spectroscopy is sent to the flux and speed measurement device 16, and the output, based upon the flux and the speed, can thus be fed back to the heating controller 3.

The embodiment described above uses a mass spectrometer as the ion source, but alternative devices may be used provided they can ionise the molecular beam.

In the apparatus for forming a thin film described above, the proportion of ionised molecules to the total flux of the molecular beam, which is used for the formation of the thin film, is generally up to 1/1000, but this proportion can be altered by adjusting the mass spectrometer.

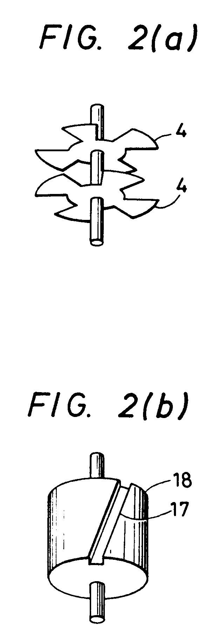

A molecular beam speed selector shown in Figure 2 can be used in place of the chopper 4. Figure 2(a) shows a speed selector in which two choppers are rotated coaxially, while Figure 2(b) shows a speed selector wich consists of a rotary cylindrical chopper 18 equipped with an inclined slit 17 on its side wall. When the rotation speed of either of the molecular beam speed selectors is changed, a molecular beam having a particular speed can be derived by utilizing the gap defined by the deviation of the blades in the case of Figure 2(a), and by utilizing the molecular beam passing through the slit 17 in the case of Figure 2(b). Therefore, a uniform thin film having better microcrystallinity can be formed.

It is possible to calculate the flux and speed of the ionised molecular beam by introducing the molecular beam itself into an ionisation chamber so as to ionise a part of the molecular beam without using the chopper described above. However, the background noise is then large and so accurate flux and speed measurements of the molecular beam cannot easily be determined. The reason is that the molecular beam does not only pass directly into the aperture, but some of the beam impinges against, and is reflected from, the wall of the apparatus and enters the ioniser, thereby causing background noise. If the molecular beam is cut by the chopper, to form a pulsed molecular beam, the part of the molecular beam which is reflected from the wall and which enters the ionisation chamber has a relative time lag, so that it enters the ionization chamber while the pulsed molecular beam is cut off. Therefore, the background noise has already disappeared by the time the pulsed molecular beam enters the ionisation chamber, and the molecular beam flux can be measured more accurately.

It is generally preferred that the modulation frequency of the chopper be from 10 Hz to 1 KHz. It is also preferred that the chopper allows the passage of from about 99/100 to about 1/100 of the total molecular beam, and more preferably from about 1/2 to about 1/20. This arrangement can substantially eliminate the background noise described above. The proportion of the molecular beam passed can be determined by the size of the holes in the chopper. The speed of the molecular beam cannot be measured in accordance with this system unless a chopper or similar is used.

Thus, as described above, a method of the present invention converts the molecular beam from the molecular beam source to a pulsed molecular beam, then introduces the pulsed molecular beam into the ionisation chamber so that the most of the beam is incident to the substrate while a part is ionised by the ionisation chamber, to ions and/or electrons which are then amplified and converted to an electrical signal. The flux and speed of the molecular beam may then be calculated. The molecular beam from the molecular beam source may be controlled on the basis of information obtained from this calculation, in this way the thin film may be formed. The present invention therefore permits control of the molecular beam from the molecular beam source and measurement of the flux and speed of the molecular beam itself used for the formation of the thin film. In this way the thickness of the resulting thin film can be controlled more easily, and a uniform thin film may be provided which is better than those obtained by the prior art systems. If a speed selector is used, a molecular beam having a low speed may be used for the formation of the thin film, so that the sticking probability of the molecules onto the susbtrate can be increased, the crystallinity of the thin film can be improved and the thin film can be formed with a high level of resolution.

## Claims

1. A method of forming a thin film in which a molecular beam (5) is generated by a beam source (2) and in which the beam is incident onto a substrate (11) to which the molecules stick and form a thin film (12);

the molecular beam is converted to a pulsed beam (5);

the pulsed beam (5) is introduced into an ionisation chamber (7), where a part of the pulsed beam (5) is ionised to ions and/or electrons and a part passes to the substrate (11);

the ions and/or electrons are amplified and converted to an electrical signal:

and the generation of the molecular beam (5) by the beam source (2) is controlled on the basis of the calculated flux and speed;

characterised in that:

the flux and speed of the molecular beam (5) are calculated using the electrical signal.

2. A method according to claim 1, wherein the pulses of the pulsed beam (5) have a frequency between 10 Hz and 1 KHz.

3. An apparatus for forming a thin film on a substrate (11), having a beam source (2) for generating a molecular beam (5) to be incident on a substrate (11) to form the thin film;

the apparatus includes means (4) for converting the molecular beam from the source (2) to a pulsed beam (5);

an ionisation chamber (7) for ionising part of the pulsed beam (5) to ions and/or electrons;

means (13,14,15,16,17) for amplifying the ions and/or electrons, converting them to an electrical signal;

characterised in that;

the apparatus has means for calculating the flux and speed of the molecular beam; and the apparatus includes feed-back means (3) for controlling the source (2) on the basis of the calculation.

4. An apparatus according to claim 3, wherein the ionisation chamber (7) is a mass spectrometer.

**Revendications**

1. Procédé pour former une pellicule mince, selon lequel un faisceau moléculaire (5) est produit par une source (2) de production du faisceau et selon lequel le faisceau est dirigé sur un substrat (11), auquel les molécules adhèrent en formant une pellicule mince (12);

le faisceau moléculaire est converti en un faisceau pulsé (5);

le faisceau pulsé (5) est introduit dans une chambre d'ionisation (7), une partie du faisceau pulsé (5) étant ionisée en ions et/ou électrons, et une partie du faisceau est transférée au substrat (11);

les ions et/ou électrons sont amplifiés et convertis en un signal électrique; et

la production du faisceau moléculaire (5) par la source de faisceau (2) est commandée sur la base du flux et de la vitesse calculés;

caractérisé en ce que :

le flux et la vitesse du faisceau moléculaire (5) sont calculés en utilisant le signal électrique.

2. Procédé selon la revendication 1, selon lequel les impulsions du faisceau pulsé (5) possèdent une fréquence comprise entre 10 Hz et 1 kHz.

3. Dispositif pour former une pellicule mince sur un substrat (11), possédant une source de faisceau servant à produire un faisceau moléculaire (5) destiné à rencontrer un substrat (11) pour former une pellicule mince;

ledit dispositif comprend des moyens (4) pour convertir le faisceau moléculaire délivré par la source (2) en un faisceau pulsé (5);

une chambre d'ionisation (7) pour ioniser une partie du faisceau pulsé (5) en ions et/ou électrons;

des moyens (13,14,15,16,17) pour amplifier les ions et/ou les électrons, et les convertir en un signal électrique;

caractérisé en ce que

le dispositif comporte des moyens pour calculer le flux et la vitesse du faisceau moléculaire; et le dispositif comprend les moyens de réaction (3) pour commander la source (2) sur la base du calcul.

4. Dispositif selon la revendication 3, dans lequel la chambre d'ionisation (7) est un spectromètre de masse.

**Patentansprüche**

1. Verfahren zur Bildung eines Dünnfilms, in dem ein Molekularstrahl (5) von einer Strahlquelle (2) erzeugt wird und auf ein Substrat (11) fällt, an dem die Moleküle haften und einen Dünnfilm (12) bilden;

der Molekularstrahl in einen gepulsten Strahl (5) umgewandelt wird;

der gepulste Strahl (5) in eine Ionisationskammer (7) eingeleitet wird, wo eine Teil des gepulsten Strahls (5) in Ionen und/oder Elektronen ionisiert wird und ein Teil zum Substrat (11) weitergeleitet wird;

die Ionen und/oder Elektronen verstärkt und in ein elektrisches Signal umgewandelt werden; und

die Erzeugung des Molekularstrahls (5) durch die Strahlquelle (2) auf der Grundlage des berechneten Flußes und der Geschwindigkeit gesteuert werden,

dadurch gekennzeichnet,

daß der Fluß und die Geschwindigkeit des Molekularstrahls (5) unter Verwendung des elektrischen Signals berechnet werden.

2. Verfahren nach Anspruch 1, wobei die Pulse des gepulsten Strahls (5) eine Frequenz zwischen 10 Hz und 1 kHz aufweisen.

3. Vorrichtung zur Bildung eines Dünnfilms auf einem Substrat (11), umfassend:

eine Strahlquelle (2) zur Erzeugung eines auf ein Substrat zur Bildung eines Dünnfilms einfallenden Molekularstrahls (5);

eine Einrichtung zur Umwandlung des Molekularstrahls der Quelle (2) in einen gepulsten Strahl (5);

eine Ionisationskammer (7) zur Ionisierung eines Teils des gepulsten Strahls (5) in Ionen und/oder Elektronen; und

eine Einrichtung (13, 14, 15, 16, 17) zur Verstärkung der Ionen und/oder Elektronen und Umwandlung in ein elektrisches Signal,

gekennzeichnet durch

eine Einrichtung zur Berechnung des Flusses und der Geschwindigkeit des Molekularstrahls und eine Rückkopplungseinrichtung (3) zur Steuerung der Quelle (2) aufgrund der Berechnung.

4. Vorrichtung nach Anspruch 3, wobei die Ionisationskammer (7) eine Massenspektrometer ist.

EP 0 160 479 B1

FIG. 1

# FIG. 2(a)

# FIG. 2(b)